# EUROPEAN PATENT SPECIFICATION

(11) **EP 0 573 968 B1**
(45) Date of publication and mention of the grant of the patent: **27.03.1996**
(21) Application number: 93109220.9
(22) Date of filing: 08.06.1993
(51) Int. Cl.: H05K 13/08

(54) **Inspection method of inclination of an IC**
Methode für Neigungsinspektion von einem integrierten Schaltungschip
Méthode d'inspection de l'inclinaison d'un circuit intégré

(30) Priority: 09.06.1992 JP 174784/92
(43) Date of publication of application: 15.12.1993
(73) Proprietor: YOZAN INC., Tokyo 155 (JP)
(72) Inventor: Matsumoto, Koji, Tokyo 112 (JP)
(74) Representative: Grünecker, Kinkeldey, Stockmair & Schwanhäusser Anwaltssozietät

(56) References cited:
- EP-A- 0 062 335
- EP-A- 0 222 072
- IEEE TRANSACTIONS ON COMPONENTS,HYBRIDS,AND MANUFACTURING TECHNOLOGY vol. 13, no. 3, September 1990, NEW YORK US pages 559 - 564 JAN P. BAARTMAN 'PLACING SURFACE MOUNT COMPONENTS USING COARSE FINE POSITIONNING AND VISION .'

## Description

The present invention relates to a method for detecting an inclination angle of an IC-package to be mounted on a circuit board.

To mount an IC on the predetermined position on a board, it is necessary to set an exact position of the IC. In order to find the exact position of the IC, it is necessary to determine the center of the IC and its angle of inclination. In case of extracting the center of the IC and its angle of inclination according to an image processing, the extracting is processed according to a binarized image in order to make the processing speed to be high in most cases. However, the binarized image is easily damaged by a change of degree of brightness of light, and might therefor be in accurate. Improvements in the processing technology of LSI have lead to an increased amount of pins. As a result, the width of each pin becomes thinner and it is impossible to exactly take in the pin as an image. Also, it is hard to calculate an angle of inclination for each pin based on image information.

It is the object of the present invention to provide a method which enables detection of an inclination angle of an IC-package to be mounted on a circuit board at high speed.

This object is solved by the subject matter of claim 1.

Figure 1 is a flow chart showing an embodiment of the present invention.

Figure 2 is a conceptual diagram showing a setting of a checking area.

Figure 3 is a conceptual diagram of a density projection of a checking area.

Figure 4 is a diagram for explaining a primary differential and a part of an edge of a checking area CR1.

Figure 5 is a diagram for explaining a primary deferential and a part of an edge of checking areas CR5 and CR6.

Figure 6 is a diagram explaining an edge position by subpixel unit.

Figure 7 is a conceptual diagram showing a representative point of a checking area.

Figure 8 is a conceptual diagram showing a center and an inclination of an IC.

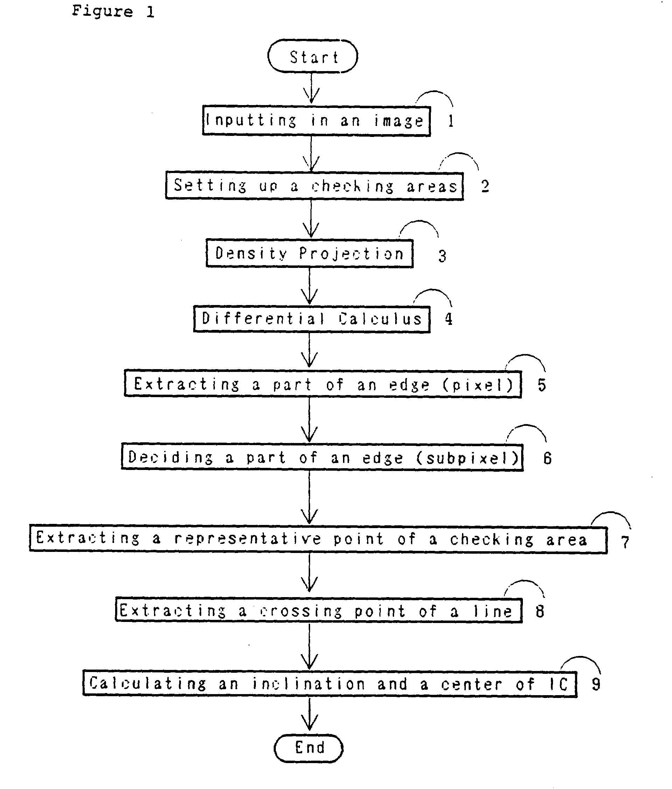

Hereinafter, an embodiment of a inspection method of inclination of an IC of the present invention is described with referring to the attached drawings. Figure 1 is a flow chart showing an embodiment of the present invention.

First, an image of IC with pins in 4 sides of QFP type etc. is taken on step 1. The value of density of the background and that of pin part has difference.

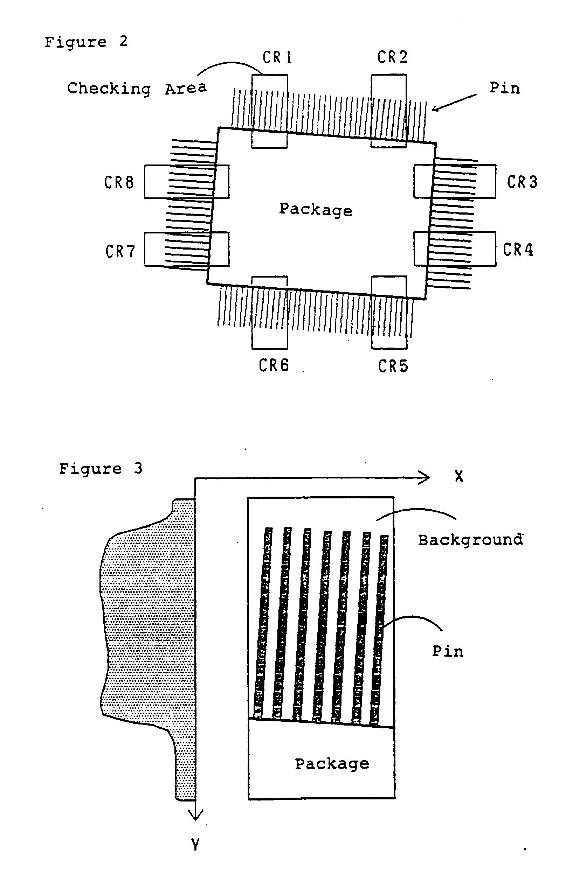

On step 2, checking areas are set in the predetermined position in the image of IC (Figure 2). Several number of a checking areas are set in each side of IC, and here, 2 checking areas are used as an example for explanation. In these areas, there must be open ends of IC pins must be involved.

A density projecting of the checking areas are generated on step 3. A checking area CR1, which is an example, generates a density projection in a direction parallel to a pin, that is Y-direction. Figure 3 shows a density projection of the checking area CRT1.

When performing a density projection of a pin part, it is not necessary to adopt information of each pin image. With improvements of LSI-technology, the number of pins increases and thus the width of each pin becomes smaller.

Furthermore, the density projection is multi-valued and a totally integrated data of light and shade of an image. The density projection has highly reliable information comparing with a binarized image lacking information, for information compression.

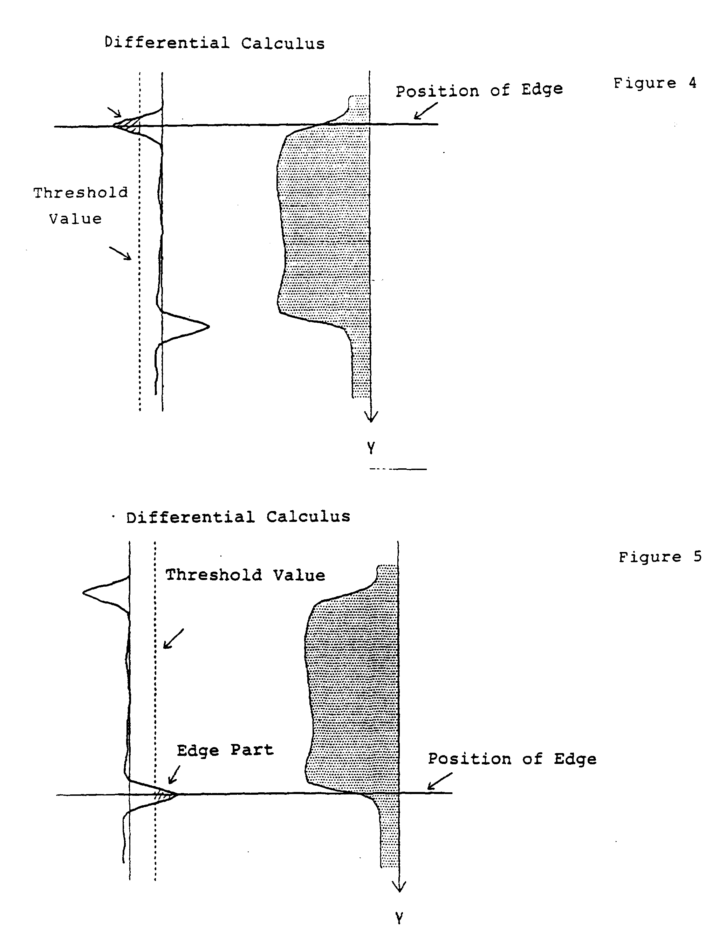

On step 4, the primary differential is performed for the density projection generated on step 3. Figure 4 shows the differential result by a thick line. As the result, a line along the open ends of IC pins, that is, a boundary point of Y-axis direction is emphasized (A boundary point is expressed by an "edge" hereafter.).

On the checking area CR1, the first rising part in a direction from large to small in Y-coordinates is to be an edge part between the background and the pin part.

In order to calculate a position of an edge on step 5, at first, thresholding is performed. That is, setting the threshold value calculated in experience shown in broken line in Figure 4, the part over the threshold value (a part of oblique lines) is judged as a part of the edge.

In order to unite a setting method of threshold value, it is better to perform normarization after a primary differential.

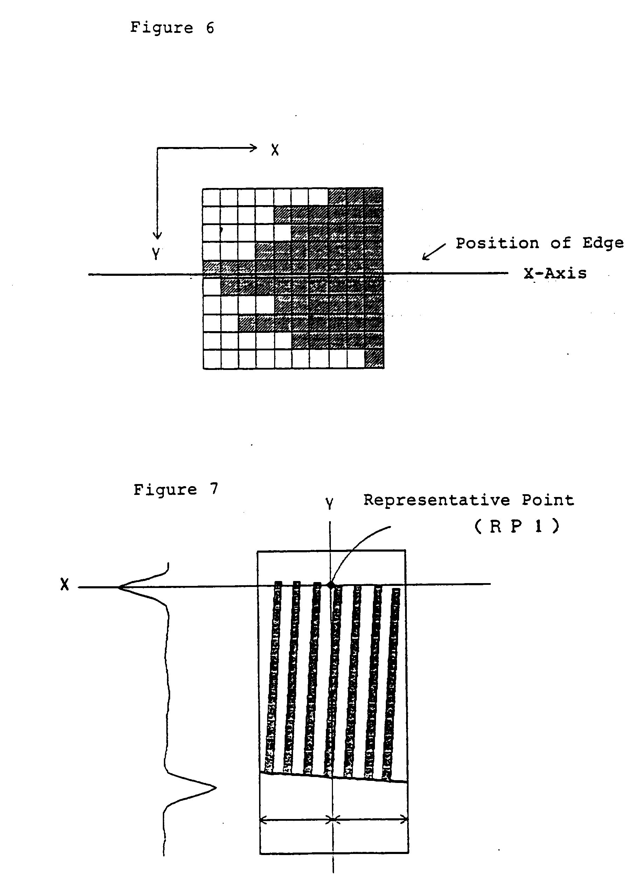

Figure 5 shows a density projection of a checking areas CR5 and CR6 positioning the opposite sides of checking areas CR1 and CR2, a figure performed a primary differential on the density projection, a threshold value (a broken line) and an edge part (an oblique lines). Naturally, in checking areas CR5 and CR6 of opposite sides of CR1 and CR2, it is defined as an edge part rising first in a Y-coordinates direction from small to large.

On step 6, a position of an edge is extracted by a subpixel unit. Figure 6 shows a part of the edge by a pixel unit of an image. It is usual that there are uneven in an image as Figure 6. In order to calculate more accurate position of the edge, that is Y-coordinates from such an image data, subpixels must be considered. As a result, it is possible to obtain a more exact and precise Y-coordinates (Figure 6 shows a line of X-axis of the coordinates.) than the method obtaining Y-coordinates by a pixel unit with the maximum value of a primary differential.

Next, calculating a X-coordinates of a central point of a width of X-axis direction of a checking area CR1 shown in Figure 7 on step 7, the crossing point of X-axis of Y-coordinates obtained on step 6 and that of Y-axis of X-coordinates are calculated. These points are defined as a representative point RP1 of a checking area CR1.

With respect to the processing from step 1 to step 7 of the checking area CR3, CR4, CR7 and CR8 of the left and the right side of the IC, X and Y-axis are contrary to the processing above. For example, a density projection is a direction of X-axis.

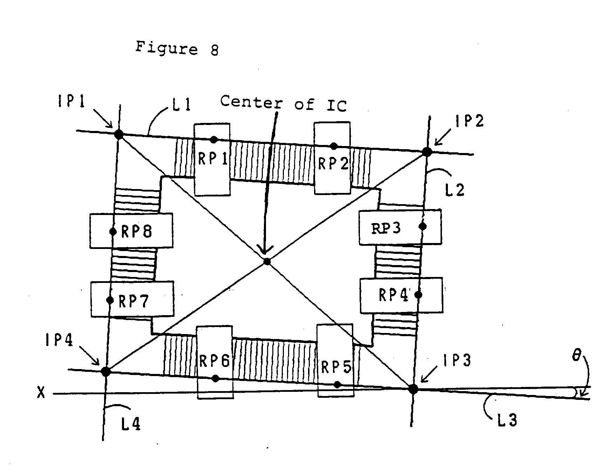

As mentioned above, each representative point in all checking areas is calculated. In Figure 8, each checking area is described from RP1 to RP8.

On step 8, as in Figure 8, lines passing through the representative points of a checking area of a side are calculated, and these lines are shown by L1, L2, L3 and L4. The crossing points of these lines are shown by IP1, IP2, IP3 and IP4.

In the case over 3 checking areas in a line are set, an approximate line corresponding to representative points of each checking area is to be obtained, for example, calculating an approximate line of the minimum squared differential, the cross points are extracted.

On step 9, drawing a line connecting IP1 and IP3, its center point is extracted and it becomes a center of IC. And, it is possible to calculate the enter of IC by extracting crossing point of two lines connecting IP1 and IP3 and connecting IP2 and IP4.

An inclined angle θ of an IC can be calculated as a crossed angle of line L3 and X-coordinates shown in Figure 8. It is also possible to calculate their mean values, for example, according to an angle of an inclination to an axis of coordinates of all lines.

As mentioned above, it is possible to calculate an inclined angle in high speed by the present invention because the checking area is small on the predetermined position and the necessary time for processing is short.

Then the calculated center of IC is defined as a center, and the IC of the inclined angle is rotated and amended its inclination.

According to the present invention it is thus possible to extract the inclination of an IC in high speed without the information of a binarized image.

## Claims

1. Method for detecting an inclination angle θ of an IC-package to be mounted on a circuit board, relative to an X- or Y-axis defined on the circuit board, said method comprising the steps of:
generating an image of the IC-package showing the relation of the IC-package relative to the circuit board,
defining a plurality of checking areas, each checking area covering open ends of pins from the package, whereby at least two checking areas (RP1; RP2; RP3; RP4; RP5; RP6; RP7; RP8) are arranged parallel to each other and to the X-axis or the Y-axis defined on the circuit board,
generating for each of said at least two checking areas an image density projection along a direction parallel to the X- or the Y-axis correspondingly,
differentiating the density projection of each of said at least two checking areas and detecting the first extreme value thereof along the corresponding X- or Y-axis in the direction towards the IC-package, and
calculating the inclination angle of the package by calculating the angle between the X-axis or the Y-axis and a connecting line (L1,L2,L3,L4) connecting said first extreme values of said at least two checking areas arranged parallel to the Y- or X-axis correspondingly.

2. Method according to claim 1, wherein the inclination angle is calculated by additionally calculating the inclination angle from connecting lines detected for further checking areas.

3. Method according to claim 2, wherein a central point of the IC-package is calculated by forming a rectangle with the connecting lines (L1, L2, L3,L4) corresponding to checking areas arranged around all four sides of the IC-package and by considering the geometrical center of this rectangle to be the center of the IC-package.

4. Method according to claim 2 or 3, wherein an average value of at least two calculated inclination angles calculated from different connecting lines is considered as the resultant inclination angle.

## Patentansprüche

1. Verfahren zum Erfassen eines Neigungswinkels θ eines auf einer Schaltplatte zu montierenden IC-Gehäuses in bezug auf eine auf der Schaltplatte definierte X- oder Y-Achse, wobei das Verfahren die folgenden Schritte umfaßt:
Erzeugen eines Bildes des IC-Gehäuses, das die Beziehung des IC-Gehäuses relativ zu der Schaltplatte zeigt,
Definieren einer Mehrzahl von Prüfbereichen, wobei jeder Prüfbereich offene Enden von Anschlußstiften des IC-Gehäuses abdeckt, wobei wenigstens zwei Prüfbereiche (RP1; RP2; RP3; RP4; RP5; RP6; RP7; RP8) parallel zueinander und zu der auf der Schaltplatte definierten X-Achse oder Y-Achse angeordnet sind,
Erzeugen für jeden der wenigstens zwei Prüfbereiche einer Bilddichteprojektion längs einer Richtung parallel zu der X- bzw. Y-Achse,
Differenzieren der Dichteprojektion jedes der wenigstens zwei Prüfbereiche und Erfassen des ersten Extremwertes davon entlang der entsprechenden X- oder Y-Achse in der Richtung auf den IC zu und
Berechnen des Neigungswinkels des Gehäuses durch Berechnen des Winkels zwischen der X-Achse oder der Y-Achse und einer Verbindungslinie (L1, L2, L3, L4), die die ersten Extremwerte der wenigstens zwei Prüfbereiche verbindet, die parallel zu der X- bzw. Y-Achse angeordnet sind.

2. Verfahren nach Anspruch 1, bei dem der Neigungswinkel berechnet wird, indem zusätzlich der Neigungswinkel von Verbindungslinien berechnet wird, die für weitere Prüfbereiche ermittelt werden.

3. Verfahren nach Anspruch 2, bei dem ein Mittelpunkt des IC-Gehäuses berechnet wird, indem ein Rechteck mit den Verbindungslinien (L1, L2, L3, L4), die den um alle vier Seiten des IC-Gehäuses herum angeordneten Prüfbereichen entsprechen, gebildet wird und die geometrische Mitte dieses Rechtecks als die Mitte des IC-Gehäuses angesehen wird.

4. Verfahren nach Anspruch 2 oder 3, bei dem ein Mittelwert von wenigstens zwei berechneten Neigungswinkeln, die von verschiedenen Verbindungslinien berechnet werden, als der sich ergebende Neigungswinkel angesehen wird.

## Revendications

1. Méthode pour détecter un angle d'inclinaison θ d'un boîtier IC destiné à être monté sur une carte de circuits imprimés, par rapport à un axe X ou Y défini sur la carte de circuits imprimés, ladite méthode comprenant les étapes de :
- génération d'une image du boîtier IC montrant la relation du boîtier IC relative à la carte de circuits imprimés,
- définition d'une pluralité de zones de vérification, chaque zone de vérification couvrant des extrémités libres de broches du boîtier, de sorte qu'au moins deux zones de vérification (RP1; RP2; RP3; RP4; RP5; RP6; RP7; RP8) sont disposées parallèlement les unes aux autres et à l'axe X ou l'axe Y défini sur la carte de circuits imprimés,
- génération pour chacune desdites au moins deux zones de vérification d'une projection de densité d'image suivant une direction parallèle à l'axe X ou Y de manière correspondante,
- différentiation de la projection de densité de chacune desdites au moins deux zones de vérification et détection de la première valeur extrême de celles-ci suivant l'axe X ou Y correspondant dans la direction vers le boîtier IC, et
- calcul de l'angle d'inclinaison du boîtier en calculant l'angle entre l'axe X ou l'axe Y et une ligne de liaison (L1, L2, L3, L4) liant lesdites premières valeurs extrêmes desdites au moins deux zones de vérification disposées parallèlement à l'axe Y ou X de manière correspondante.

2. Méthode selon la revendication 1, dans laquelle l'angle d'inclinaison est calculé en calculant additionnellement l'angle d'inclinaison à partir de lignes de liaison détectées pour d'autres zones de vérification.

3. Méthode selon la revendication 2, dans laquelle un point central du boîtier IC est calculé en formant un rectangle avec les lignes de liaison (L1, L2, L3, L4) correspondant à des zones de vérification disposées autour des quatre côtés du boîtier IC et en considérant le centre géométrique de ce rectangle comme étant le centre du boîtier IC.

4. Méthode selon la revendication 2 ou 3, dans laquelle une valeur moyenne d'au moins deux angles d'inclinaison calculés à partir de lignes de liaison différentes est considérée comme l'angle d'inclinaison résultant.
